# EUROPÄISCHE PATENTSCHRIFT

(11) **EP 3 555 603 B1**
(45) Veröffentlichungstag und Bekanntmachung des Hinweises auf die Patenterteilung: **02.06.2021**
(21) Anmeldenummer: 17816600.5
(22) Anmeldetag: 04.12.2017
(51) Int. Cl.: G01N 24/08, G01R 33/46, G01R 33/465

(54) **NMR-VERFAHREN ZUR DETEKTION UND QUANTIFIZIERUNG VON EINZELNEN ANALYTEN IN FLÜSSIGEN ANALYTGEMISCHEN**
NMR METHOD FOR DETECTING AND QUANTIFYING INDIVIDUAL ANALYTES IN LIQUID ANALYTE MIXTURES
PROCÉDÉ DE RMN POUR DÉTECTER ET QUANTIFIER DIFFÉRENTS ANALYTES DANS DES MÉLANGES D'ANALYTES LIQUIDES

(30) Priorität: 13.12.2016 DE 102016124177
(43) Veröffentlichungstag der Anmeldung: 23.10.2019
(73) Patentinhaber: Leibniz - Institut für Analytische Wissenschaften - ISAS - e.V., 44139 Dortmund (DE)
(72) Erfinder: TELFAH, Ahmad, 44137 Dortmund (DE); HERGENRÖDER, Roland, 44229 Dortmund (DE); LAMBERT, Jörg, 48308 Senden (DE)
(74) Vertreter: Meinke, Jochen
(86) Internationale Anmeldenummer: PCT/EP2017/081314
(87) Internationale Veröffentlichungsnummer: WO 2018/108600

(56) Entgegenhaltungen:
- WO-A1-2016/189536
- US-A1- 2011 175 614
- RAY FREEMAN: "Shaped radiofrequency pulses in high resolution NMR", PROGRESS IN NUCLEAR MAGNETIC RESONANCE SPECTROSCOPY., Bd. 32, Nr. 1, 12. Februar 1998 (1998-02-12), Seiten 59-106, XP055452070, GB ISSN: 0079-6565, DOI: 10.1016/S0079-6565(97)00024-1
- BLUEMICH B ET AL: "Mobile single-sided NMR", PROGRESS IN NUCLEAR MAGNETIC RESONANCE SPECTROSCOPY, PERGAMON PRESS, OXFORD, GB, Bd. 52, Nr. 4, 28. Dezember 2007 (2007-12-28), Seiten 197-269, XP022589395, ISSN: 0079-6565, DOI: 10.1016/J.PNMRS.2007.10.002 [gefunden am 2007-12-28]

## Beschreibung

Die Erfindung betrifft ein Verfahren zur Detektion und Quantifizierung wenigstens eines einzelnen Analyten in flüssigen Analytgemischen mittels der NMR-Spektrometrie, bei welchem eine Probe des Analytgemisches in einem NMR-Spektrometer mit einem Hochfrequenzpuls beaufschlagt und das resultierende NMR-Spektrum ausgewertet wird, wobei die Probe des Analytgemisches in einem Niederfeld-NMR-Spektrometer angeordnet wird.

Eine genaue Analyse von flüssigen Analytgemischen ist in vielen Anwendungsfällen erforderlich oder zumindest wünschenswert. Zu diesem Zweck ist die hoch aufgelöste Kernresonanzspektroskopie (NMR) grundsätzlich geeignet. Ein solches NMR-Spektrometer mit einer Magnetfeldstärke von mehr als 20 T (Tesla) ist jedoch äußerst kostenaufwendig und steht deshalb in der Regel nicht zur Verfügung. Auch die Massenspektrometrie ist grundsätzlich zur Analyse geeignet. Auch solche Massenspektrometer sind aufwendig und kostenintensiv, so dass beide vorgenannten Analyseinstrumente für Anwendungen vor Ort, z.B. in Arztpraxen oder auch in Sicherheitskontrolleinrichtungen an Flughäfen oder dgl., nicht zur Verfügung stehen.

Gerade aber im Bereich der Vorhersage, Diagnose, Überwachung und Prognose von Krankheiten sowie bei der Optimierung von Medikamentendosierungen wäre es wünschenswert, ein kostengünstiges Vor-Ort-Analyseverfahren zur Verfügung zu haben. Eine Schlüsselrolle kommt in diesem Zusammenhang der Analyse der Stoffwechselendprodukte (Metabolite) eines Patienten zu. Die Konzentrationen von Schlüsselmetaboliten in den Körperflüssigkeiten Blut und Urin erlauben grundsätzlich eine differenzierte Vorhersage des Gesundheitszustandes und potentieller Gesundheitsrisiken.

Die in der heutigen klinischen Analytik praktizierte Auswertung einer kleinen Zahl von Biomarkern, wie Triglyzeriden und Cholesterol, reicht jedoch nicht aus, um das Risiko des Auftretens von Krankheiten in jedem Fall sicher vorherzusagen. Derartige einfache Biomarkervorhersagen unterschätzen die inhärente Komplexität metabolischer Störungen, die Hunderte von biochemischen Prozessen einschließen. An die Erstellung eines kompletten metabolischen Profils aus Biofluiden ist jedoch bisher in der klinischen Analytik aus Kostengründen nicht zu denken. Im Gegensatz zum Genom oder Proteom, die mit Hilfe kostengünstiger Array-Technologien analysiert werden können, sind vergleichbare effiziente und kostengünstige Diagnosetools für das Metabolom bisher nicht verfügbar. Wie vorerwähnt, sind solche Analysen zwar grundsätzlich mit Hilfe von Massenspektrometern oder hoch aufgelösten Kernresonanzspektrometern möglich, deren Einsatz aber vor Ort ausscheidet.

Grundsätzlich bekannt sind auch preiswerte und portable Niederfeld-NMR-Spektrometer mit Magnetfeldstärken bis etwa 3 T. Diese Niederfeld-NMR-Spektrometer kommen zunehmend auf den Markt und werden zur Messung des Fettgehaltes von Lebensmitteln sowie als Detektoren für die Flüssigchromatografie eingesetzt. Viele der heute eingesetzten portablen NMR-Systeme verfügen jedoch über Magnete mit einer geringen Homogenität und werden daher für relaxometrische Untersuchungen zur Bestimmung des Wassergehaltes von Lebensmitteln sowie zur Qualitätskontrolle von Elastomeren verwendet. Für klassische NMR-spektroskopische Untersuchungen, wie der Produktkontrolle in der organischen Synthese, gibt es kommerzielle Geräte, die sich allerdings nur für reine Probensubstanzen mit gut separierten Signalen eignen. Diese Geräte werden gewöhnlich zu Ausbildungszwecken eingesetzt und erreichen durchaus Linienbreiten, die die Auflösung von Multipletts erlauben. Niedrigfeld-NMR-Spektrometer, die für die Charakterisierung von Substanzgemischen und dabei insbesondere zur eindeutigen Erkennung und zuverlässigen Quantifizierung der Metabolite in Blut und Urin geeignet sind, sind bisher nicht verfügbar, da die spektrale Dispersion bei niedrigen Magnetfeldstärken viel zu klein ist.

Aus WO 2016/189536 A1 ist ein Verfahren mit den Merkmalen des Oberbegriffs des Patentanspruchs 1 bekannt. Dieses Verfahren dient insbesondere zur Messung des Fettgehaltes von Lebensmitteln.

Aufgabe der Erfindung ist es, ein Verfahren der eingangs beschriebenen Art so weiter zu entwickeln, dass es auch bei Verwendung von Niederfeld-NMR-Spektrometern eine exakte Analyse von flüssigen Analytgemischen ermöglicht.

Diese Aufgabe wird bei einem Verfahren der eingangs bezeichneten Art erfindungsgemäß dadurch gelöst, dass die Probe mit wenigstens einem nur einen spezifischen Analyten anregenden Hochfrequenzpuls beaufschlagt wird, wobei der Hochfrequenzpuls so ausgestaltet ist, dass er den Analyten selektiv an allen Positionen anregt, an denen im NMR-Spektrum Signale erscheinen.

Wie vorerwähnt, ist grundsätzlich die Niederfeld-NMR-Spektrometrie nicht zur Analyse von Substanzgemischen, z.B. zur zuverlässigen Quantifizierung der Metabolite in Blut und Urin geeignet, da in den NMR-Spektren von Biofluiden eine massive Überlagerung von Metaboliten- und Matrix-Signalen auftritt, die eine sinnvolle Analyse unmöglich machen. Erfindungsgemäß wird deshalb die jeweilige Probe des Analytgemisches in einen Niederfeld-NMR-Spektrometer nicht mit dem üblichen Hochfrequenzpuls beaufschlagt, sondern es wird für den jeweils gesuchten Analyten ein nur diesen Analyten anregender Hochfrequenzpuls ermittelt und die Probe nur mit diesem analytspezifischen Hochfrequenzpuls beaufschlagt.

Dabei wird erfindungsgemäß unter einem analytspezifischen Hochfrequenzpuls ein Hochfrequenzpuls verstanden, der in der Lage ist, eine ganze Serie von Frequenzbändern anzuregen, und zwar genau an allen Positionen, an denen bei einem bestimmten Analyten Signale im NMR-Spektrum erscheinen. Dadurch wird nur der entsprechende Analyt angeregt und bei Vorhandensein desselben in der Probe ist der Analyt im NMR-Spektrum eindeutig detektierbar und quantifizierbar. So kann z.B. bei einer Sicherheitskontrolle an einem Flughafen oder dgl. eine flüssige Probe auf diese Weise gezielt auf einen bestimmten Analyten hin analysiert werden, indem die Probe mit einem nur diesen spezifischen Analyten anregenden Hochfrequenzpuls beaufschlagt wird. Ist der Analyt dann im NMR-Spektrum zu erkennen, so enthält die Probe diesen Analyten, ansonsten ist der Analyt in der Probe nicht enthalten.

In den meisten Anwendungsfällen ist bevorzugt vorgesehen, dass die Probe des Analytgemisches nacheinander mit mehreren, jeweils nur einen spezifischen Analyten anregenden Hochfrequenzpulsen beaufschlagt wird, wobei nach jeder Hochfrequenzpulsbeaufschlagung das resultierende NMR-Spektrum ausgewertet wird. Anders als bei der klassischen NMR-Spektrometrie wird somit die Probe nicht nur mit einem einzigen Hochfrequenzpuls beaufschlagt, sondern nacheinander mit mehreren, jeweils nur einen spezifischen Analyten anregenden Hochfrequenzpuls, d.h. es wird sukzessive untersucht, ob die Probe verschiedene Analyten bzw. Analytsubstanzen enthält oder nicht. Somit ist eine exakte Analyse von Substanzgemischen und dabei insbesondere eine eindeutige Erkennung und zuverlässige Quantifizierung z.B. der Metabolite in Blut und Urin mit einfachen, kostengünstigen Niederfeld-NMR-Spektrometern möglich.

In bevorzugter Ausgestaltung ist vorgesehen, dass das Magnetfeld des Niederfeld-NMR-Spektrometers eine Magnetstärke zwischen 0,1 und 3,0 T aufweist. Derartige Niederfeld-NMR-Spektrometer sind verfügbar und weisen einen vergleichsweise geringen Kostenaufwand auf, so dass sie z.B. in Arztpraxen oder auch an Sicherheitskontrollstationen eingesetzt werden können.

Zur Durchführung des Verfahrens ist bevorzugt vorgesehen, dass für eine Vielzahl von Analyten ein für den jeweiligen Analyten spezifischer, nur diesen Analyten anregender Hochfrequenzpuls ermittelt und archiviert wird. Die jeweiligen Hochfrequenzpulse sind dann im jeweiligen Niederfeld-NMR-Spektrometer abgespeichert und können je nach gesuchtem Analyten ausgewählt und dann auf die Probe angewendet werden.

Zur Ermittlung des jeweiligen Hochfrequenzpulses ist bevorzugt vorgesehen, dass der jeweilige, nur einen spezifischen Analyten anregende Hochfrequenzpuls numerisch iterativ ermittelt wird. Der Hochfrequenzpuls kann z.B. nach dem Prinzip der sogenannten optimalen Kontrolle berechnet werden. So kann z.B. ein Krotov-Verfahren eingesetzt werden, das sich für komplexe Systeme mit vielen verschiedenen Wasserstoffkernen als der am besten geeignete Algorithmus erwiesen hat. Der Krotov-Algorithmus verfügt über ein streng monotones Konvergenzverhalten und benötigt zur Optimierung der Hochfrequenzpulse keine Gradiententechniken, die zu suboptimalen Lösungen führen könnten.

Die Erfindung ist nachstehend anhand der Zeichnung beispielhaft näher erläutert. Diese zeigt in
- Figur 1: ein nicht analysierbares Gesamt-NMR-Spektrum eines Biofluids,
- Figur 2: ein Gesamt-NMR-Spektrum eines nur aus zwei Analyten (Alanin und Laktat) bestehenden Analytgemisches,
- Figur 3: den zeitabhängigen Amplitudenverlauf des Hochfrequenzpulses zum Gesamt-NMR Spektrum nach Figur 2,
- Figur 4: den zeitabhängigen Phasenverlauf des Hochfrequenzpulses zum Gesamt-NMR-Spektrum nach Figur 2,
- Figur 5: das NMR-Spektrum des reinen Analyten Alanin,
- Figur 6: den zeitabhängigen Amplitudenverlauf eines Hochfrequenzpulses für Alanin zu Beginn der Iteration,
- Figur 7: den zugehörigen Phasenverlauf des Hochfrequenzpulses nach Figur 6,
- Figur 8: das Gesamt-NMR-Spektrum nach Figur 2 in kleinerem Maßstab,
- Figur 9: das alaninspezifische NMR-Spektrum aufgrund der Anregung mit einem Hochfrequenzpuls nach den Figuren 6 und 7,
- Figur 10: den zeitabhängigen Amplitudenverlauf eines Hochfrequenzpulses für Alanin in der Mitte der Iteration,
- Figur 11: den zugehörigen Phasenverlauf des Hochfrequenzpulses nach Figur 10,
- Figur 12: das Gesamt-NMR-Spektrum nach Figur 2 in kleinerem Maßstab,
- Figur 13: das alaninspezifische NMR-Spektrum aufgrund der Anregung mit einem Hochfrequenzpuls nach Figuren 10 und 11,
- Figur 14: den zeitabhängigen Amplitudenverlauf eines Hochfrequenzpulses für Alanin am Ende der Iteration,
- Figur 15: den zugehörigen Phasenverlauf des Hochfrequenzpulses nach Figur 14,
- Figur 16: das Gesamt-NMR-Spektrum nach Figur 2 in kleinerem Maßstab sowie in
- Figur 17: das alaninspezifische NMR-Spektrum aufgrund der Anregung mit einem Hochfrequenzpuls nach den Figuren 14 und 15.

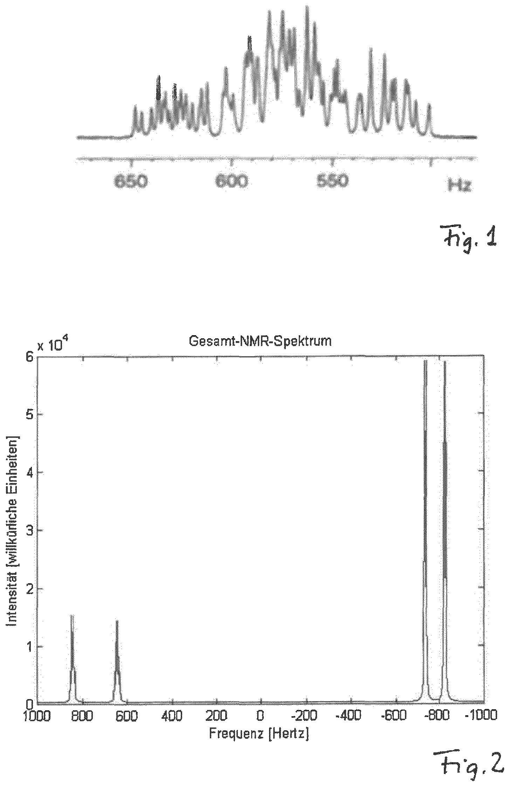

In Figur 1 ist beispielhaft ein Gesamt-NMR-Spektrum eines Biofluids dargestellt, das in einem Niederfeld-NMR-Spektrometer erhalten worden ist. Es ist unschwer zu erkennen, dass ein solches NMR-Spektrum nicht analysierbar ist.

Um gleichwohl Niederfeld-NMR-Spektrometer zur Analyse von flüssigen Analytgemischen verwenden zu können, wird das vorbeschriebene, erfindungsgemäße Verfahren eingesetzt.

Figur 2 zeigt ein Gesamt-NMR-Spektrum eines Analytgemisches, das zur einfacheren Erklärung nur aus zwei Analyten besteht, nämlich Laktat und Alanin. Dieses in Figur 2 dargestellte Spektrum wäre somit grundsätzlich bereits sinnvoll auszuwerten. Im Nachfolgenden wird jedoch zur Erläuterung des erfindungsgemäßen Verfahrens unterstellt, dass das in Figur 2 dargestellte Spektrum nicht analysierbar ist.

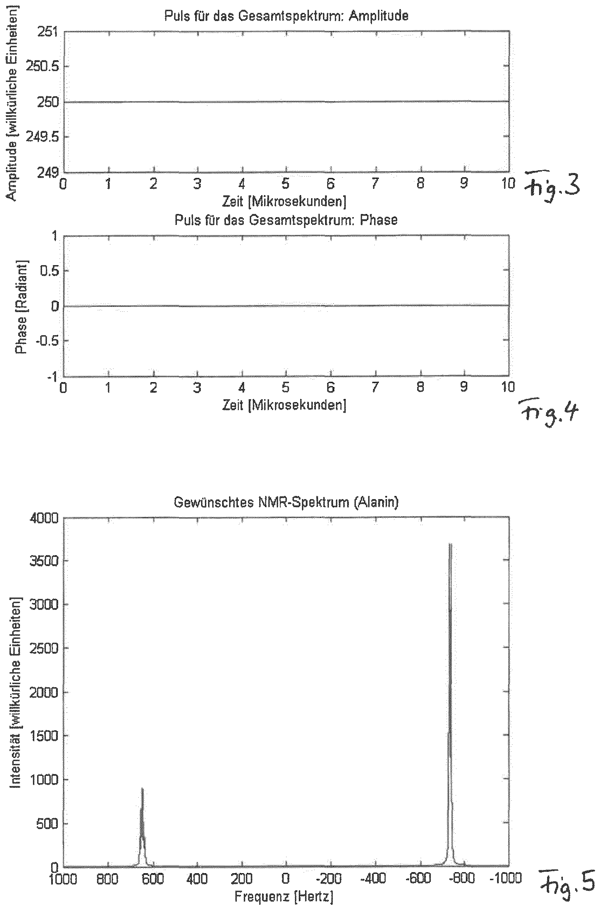

Das in Figur 2 dargestellte Spektrum entsteht dadurch, dass eine in einem Niederfeld-NMR-Spektrometer angeordnete, nur aus Laktat und Alanin bestehende flüssige Probe mit einem Hochfrequenzpuls beaufschlagt wird, der in den Figuren 3 und 4 dargestellt ist. Bei der Intensität in Figur 2 ist eine "willkürliche Einheit" gewählt, was üblich ist, da die genaue Intensität (eine Spannung) sehr stark von der Hardware (Feldstärke des Magneten, Vorverstärker) abhängt, die man zur Detektion benutzt. Also wird jeder NMR-Spektroskopiker für ein und denselben Puls eine andere Spannung messen, je nachdem welches Gerät er verwendet.

Normalerweise liegen die absoluten Frequenzen in der NMR im Bereich von 5 MHz bis ca. 1 GHz (Radiowellen- bis unterer Mikrowellenbereich). Die Unterschiede der Frequenzen zwischen verschiedenen NMR-Signalen liegen dagegen im Bereich von kHz. Die Frequenzskalen würden also sehr große Zahlen enthalten, die sich nur geringfügig unterscheiden und wären schwer zu lesen. Daher subtrahiert man von allen Frequenzen eine Trägerfrequenz im MHz-Bereich und stellt nur die Änderungen relativ zu dieser Trägerfrequenz dar. Die Trägerfrequenz wird in die Mitte des Spektrums gesetzt, so dass sich für die "kleinen" Änderungen zwischen den Signalen positive und negative Frequenzen ergeben. Die Frequenzskala läuft entgegen der Konvention von rechts nach links, d.h. die positiven Frequenzen befinden sich auf der linken Seite der x-Achse. Das hat historische Gründe und wird bis heute in dieser Weise verwendet.

Figur 5 zeigt das gewünschte NMR-Spektrum für Alanin. Wenn erfindungsgemäß die nur aus Laktat und Alanin bestehende flüssige Probe in einem Niederfeld-NMR-Spektrometer mit einem für Alanin spezifischen Hochfrequenzpuls, d.h. nur Alanin anregenden Hochfrequenzpuls, beaufschlagt wird, so würde das in Figur 5 dargestellte NMR-Spektrum entstehen, wenn Alanin tatsächlich in der Probe in entsprechender Menge enthalten ist. Dabei wird erfindungsgemäß unter einem hier für Alanin spezifischen Hochfrequenzpuls ein Hochfrequenzpuls verstanden, der in der Lage ist, eine ganze Serie von Frequenzbändern anzuregen, und zwar genau an allen Positionen, an denen bei Alanin Signale im NMR-Spektrum erscheinen.

Zur Ermittlung eines analytspezifischen NMR-Hochfrequenzpulses, in diesem Falle also alaninspezifischen Pulses, wird wie folgt vorgegangen:
Ein NMR-Experiment wird dabei prinzipiell wie folgt durchgeführt: Auf eine Spule, die um ein Glasröhrchen mit dem Analytgemisch (auch "Probe" genannt) gewickelt ist, wird mit einem HF-Generator ein Hochfrequenzpuls von typischerweise 10 µs Länge gegeben. Durch die Einwirkung des Pulses wird in dem Analytgemisch ein zeitlich veränderliches magnetisches Moment erzeugt. Durch eine geeignete technische Vorrichtung wird die Spule vom "Sendemodus" in den "Empfangsmodus" überführt. Das zeitlich veränderliche magnetische Moment der Probe induziert dann in der Spule eine Spannung, die für ca. 500 ms als Funktion der Zeit gemessen und mit einem Analog-Digital-Wandler digitalisiert wird. Nach der Fourier-Transformation des digitalisierten Zeitsignals entsteht eine Darstellung der Formamplitude als Funktion der Frequenz, die als NMR-Spektrum bezeichnet wird.

Ohne weitere Vorkehrungen enthält das NMR-Spektrum die NMR-Signale von allen Analyten bzw. Substanzen des Analytgemisches, also Laktat und Alanin gemäß Figur 2.

Gesucht wird ein Hochfrequenzpuls, der in einem NMR-Experiment, das an einer Mischung von mehreren Substanzen durchgeführt wird, nur das NMR-Spektrum von einer (frei auswählbaren) Substanz aus der Mischung liefert. Dazu wird die Methode der "Optimalen Kontrolle" benutzt. Dieses iterative numerische Verfahren optimiert ein Funktional. Darunter versteht man einen Ausdruck, der eine mathematische Funktion übergeben bekommt und eine Zahl zurückliefert. Ziel des Algorithmus ist es, das Funktional iterativ zu maximieren. Die dem Funktional übergebene Funktion ist eine Qualitätsfunktion, die den gerade erreichten Ist-Zustand des Pulses (also das Spektrum, das der Puls zum Zeitpunkt der Rechnung wirklich liefert) mit dem Soll-Zustand (also das Spektrum, das der Puls idealerweise liefern sollte) vergleicht. Das Funktional liefert besonders große Werte, wenn der Ist- und der Soll-Zustand übereinstimmen. Das wäre dann der gewünschte Zustand, in dem der Puls genau das NMR-Spektrum erzeugt, das man haben möchte.

Der Soll-Zustand wird so festgelegt, dass im resultierenden NMR-Spektrum nur die Signale der gewünschten Substanz erscheinen. Dies ist immer einfach möglich, weil die NMR-Spektren aller Substanzen der Mischung bekannt sind. Zur Berechnung des Ist-Zustands wird der Puls durch ein Histogramm von etwa 200 rechteckigen Pulsen, die sehr kurz sind (ca. 50 µs), ersetzt. In diesem Fall kann man das NMR-Spektrum, das ein solcher kurzer Rechteckpuls erzeugt, relativ einfach berechnen. Eine solche Berechnung ist bekannt, z.B. aus der Zeitschrift Progress in NMR Spectroscopy, Vol. 16, pp. 163-192, 1983.

Für die Berechnung des NMR-Spektrums, das der Gesamthochfrequenzpuls erzeugt, muss man sukzessive alle Rechteckpulse des Histogramms berücksichtigen. Die Berechnung der Qualitätsfunktion zeigt dann an, wie weit der Ist-Zustand noch vom Soll-Zustand entfernt ist. Ist die Qualitätsfunktion noch nicht zufriedenstellend, werden die Amplituden der einzelnen Rechteckpulse des Histogramms verändert und eine neue Iteration beginnt. In welcher Weise die Amplituden der 200 Rechteckpulse zu verändern sind, wird durch eine im Rahmen des Algorithmus gegebene analytische Aktualisierungsregel festgelegt. Diese Aktualisierungsregel stellt sicher, dass die Qualitätsfunktion und damit das Funktional mit jeder Iteration streng monoton wächst. Die Berechnung wird nach einer vorher durch empirische Tests festzulegenden Anzahl von Iterationen abgebrochen, da es kein Kriterium gibt, das eine Maximalzahl von Iterationen festzulegen erlaubt.

In den Figuren 5 bis 17 ist beispielhaft die Ermittlung eines nur Alanin anregenden, also alaninspezifischen Hochfrequenzpulses dargestellt.

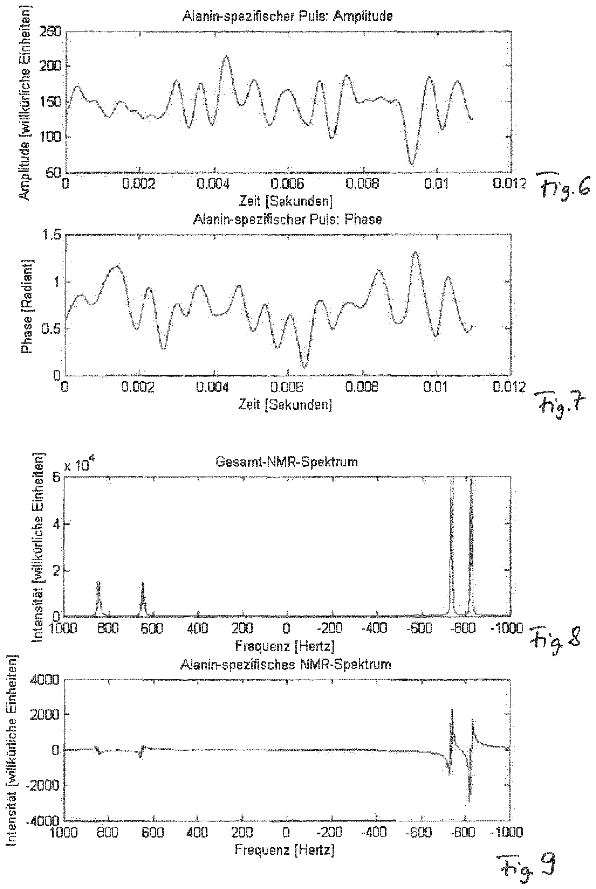

Zu Beginn der Iteration wird zum Beispiel gemäß Figuren 6 und 7 ein alaninspezifischer Hochfrequenzpuls verwendet, der noch relativ nahe an den Hochfrequenzpuls für das gesamte Spektrum gemäß Figuren 3 und 4 angenähert ist. Daraus resultiert ein noch sehr schlechtes Alanin spezifisches NMR-Spektrum gemäß Figur 9, welches sich jedoch bereits vom Gesamt-NMR-Spektrum gemäß Figur 8 (bzw. Figur 2) unterscheidet.

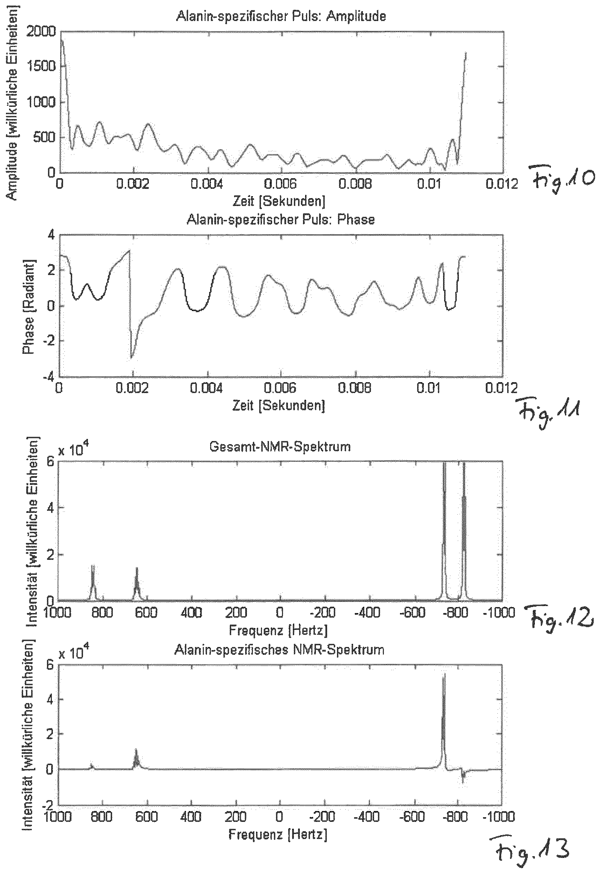

Der alaninspezifische Hochfrequenzpuls wird nachfolgend immer weiter modifiziert, in den Figuren 10 und 11 ist beispielhaft ein alaninspezifischer Hochfrequenzpuls in der Mitte der Iteration dargestellt. Daraus resultiert ein alaninspezifisches NMR-Spektrum gemäß Figur 13, das sich bereits deutlich vom Gesamt-NMR-Spektrum gemäß Figur 12 (bzw. Figur 2) unterscheidet und sich sozusagen bereits in Richtung des gewünschten Alanin-NMR-Spektrums gemäß Figur 5 entwickelt.

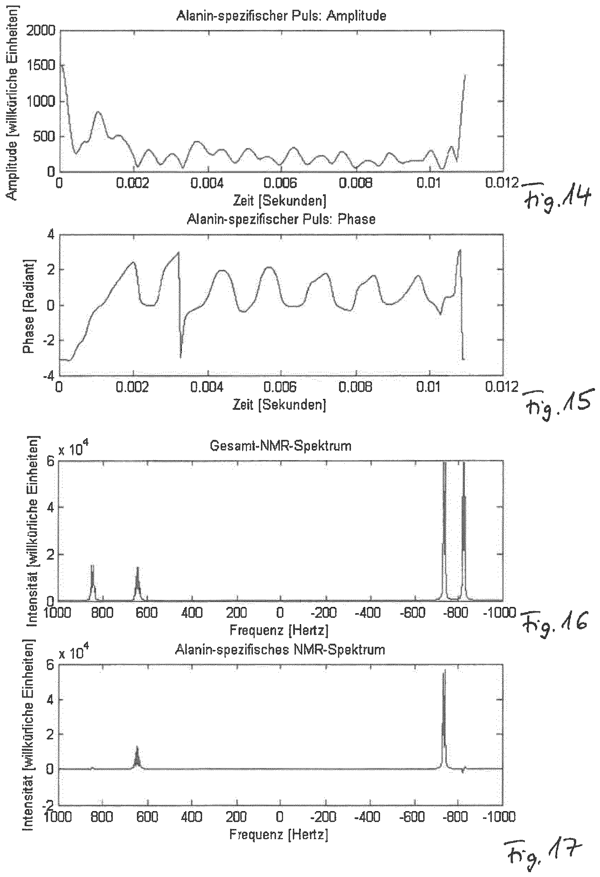

Am Ende der Iteration ergibt sich ein alaninspezifischer Hochfrequenzpuls gemäß Figuren 14 und 15. Daraus resultiert ein alaninspezifisches NMR-Spektrum gemäß Figur 17, welches sich deutlich vom Gesamt NMR-Spektrum gemäß Figur 16 (bzw. Figur 2) unterscheidet und weitestgehend dem gewünschten alaninspezifischen NMR-Spektrum gemäß Figur 5 entspricht. Somit ist ein für alaninspezifischer Hochfrequenzpuls (Figuren 14 und 15) gefunden, welcher im Niederfeld-NMR-Spektrometer archiviert bzw. abgespeichert wird. Dieser für Alanin spezifische Hochfrequenzpuls ist also ein Hochfrequenzpuls, der in der Lage ist, eine ganze Serie von Frequenzbändern anzuregen, und zwar genau an allen Positionen, an denen bei Alanin Signale im NMR-Spektrum erscheinen.

Wird nun eine flüssige Probe in ein Niederfeld-NMR-Spektrometer eingesetzt und soll diese Probe im Hinblick auf das Vorhandensein und die Menge von Alanin untersucht werden, so wird der abgespeicherte alaninspezifische Hochfrequenzpuls verwendet und die Probe mit diesem beaufschlagt. Ist Alanin in der Probe vorhanden, so entsteht ein für Alanin typisches NMR-Spektrum. Ist dagegen in der Probe kein Alanin enthalten, so ist im NMR Spektrum neben Rauschsignalen nichts erkennbar, d.h. Alanin ist nicht nachweisbar.

Auf die gleiche Weise werden für andere Analyten bzw. Substanzen entsprechend spezifische Hochfrequenzpulse ermittelt. Bei einer Untersuchung einer Probe, also eines Analytgemisches auf verschiedene Analyten, wird dann nachfolgend die Probe mit unterschiedlichen analytspezifischen Hochfrequenzpulsen beaufschlagt, wobei jeweils zwischenzeitlich eine Auswertung erfolgt, d.h. das jeweilige NMR-Spektrum ausgewertet und festgestellt wird, ob und in welcher Konzentration der jeweilige Analyt vorhanden ist.

## Patentansprüche

1. Verfahren zur Detektion und Quantifizierung wenigstens eines einzelnen Analyten in flüssigen Analytgemischen mittels der NMR-Spektrometrie, bei welchem eine Probe des Analytgemisches in einem NMR-Spektrometer mit einem Hochfrequenzpuls beaufschlagt und das resultierende NMR-Spektrum ausgewertet wird, wobei die Probe des Analytgemisches in einem Niederfeld-NMR-Spektrometer angeordnet wird,
**dadurch gekennzeichnet,**
**dass** die Probe mit wenigstens einem nur einen spezifischen Analyten anregenden Hochfrequenzpuls beaufschlagt wird, wobei der Hochfrequenzpuls so ausgestaltet ist, dass er den Analyten selektiv an allen Positionen anregt, an denen im NMR-Spektrum Signale erscheinen.

2. Verfahren nach Anspruch 1,
**dadurch gekennzeichnet,**
**dass** die Probe des Analytgemisches nacheinander mit mehreren, jeweils nur einen spezifischen Analyten anregenden Hochfrequenzpulsen beaufschlagt wird, wobei nach jeder Hochfrequenzpulsbeaufschlagung das resultierende NMR-Spektrum ausgewertet wird.

3. Verfahren nach Anspruch 1 oder 2,
**dadurch gekennzeichnet,**
**dass** das Magnetfeld des Niederfeld-NMR-Spektrometers eine Magnetstärke zwischen 0,1 und 3,0 T aufweist.

4. Verfahren nach Anspruch 1, 2 oder 3,
**dadurch gekennzeichnet,**
**dass** für eine Vielzahl von Analyten ein für den jeweiligen Analyten spezifischer, nur diesen Analyten anregender Hochfrequenzpuls ermittelt und archiviert wird.

5. Verfahren nach Anspruch 4,
**dadurch gekennzeichnet,**
**dass** der jeweilige nur einen spezifischen Analyten anregende Hochfrequenzpuls numerisch iterativ ermittelt wird.

## Claims

1. Method for detecting and quantifying at least one individual analyte in liquid analyte mixtures by means of NMR spectrometry, in which method a high-frequency pulse is applied to a sample of the analyte mixture in an NMR spectrometer and the resulting NMR spectrum is evaluated, wherein the sample of the analyte mixture is arranged in a low-field NMR spectrometer,
**characterised in**
**that** at least one high-frequency pulse that excites only one specific analyte is applied to the sample, wherein the high-frequency pulse is configured in such a way that it selectively excites the analyte at all points where signals appear in the NMR spectrum.

2. Method according to claim 1,
**characterised in**
**that** multiple high-frequency pulses, each exciting only one specific analyte, are applied one after the other to the sample of the analyte mixture, wherein the resulting NMR spectrum is evaluated after every high-frequency pulse application.

3. Method according to claim 1 or 2,
**characterised in**
**that** the magnetic field of the low-field NMR spectrometer has a magnetic intensity between 0.1 and 3.0 T.

4. Method according to claim 1, 2 or 3,
**characterised in**
**that** a high-frequency pulse that is specific to the respective analyte and excites only this analyte is determined and archived for a plurality of analytes.

5. Method according to claim 4,
**characterised in**
**that** the respective high-frequency pulse that excites only one specific analyte is determined in a numerically iterative manner.

## Revendications

1. Procédé de détection et de quantification d'au moins un analyte individuel dans des mélanges d'analytes liquides au moyen de la spectrométrie RMN, dans lequel un échantillon du mélange d'analytes est soumis à une impulsion haute fréquence dans un spectromètre RMN puis le spectre RMN résultant est évalué, dans lequel l'échantillon du mélange d'analytes est placé dans un spectromètre RMN à faible champ,
**caractérisé en ce que**,
l'échantillon est soumis à au moins une impulsion haute fréquence n'excitant qu'un analyte spécifique, dans lequel l'impulsion haute fréquence est conçue de manière à exciter les analytes sélectivement pour toutes les positions au niveau desquelles apparaissent des signaux dans le spectre RMN.

2. Procédé selon la revendication 1,
**caractérisé en ce que**,
l'échantillon du mélange d'analytes est soumis successivement à plusieurs impulsions haute fréquence n'excitant respectivement qu'un analyte spécifique, dans lequel le spectre RMN résultant est évalué après chaque exposition à une impulsion haute fréquence.

3. Procédé selon la revendication 1 ou 2,
**caractérisé en ce que**,
le champ magnétique du spectromètre RMN à faible champ présente une intensité magnétique comprise entre 0,1 et 3,0 T.

4. Procédé selon la revendication 1, 2 ou 3,
**caractérisé en ce que**,
pour un grand nombre d'analytes, une impulsion haute fréquence spécifique à l'analyte respectif et n'excitant que ledit analyte est déterminée et archivée.

5. Procédé selon la revendication 4,
**caractérisé en ce que**,
l'impulsion haute fréquence respective n'excitant qu'un analyte spécifique est déterminée numériquement de manière itérative.
